# EUROPÄISCHE PATENTSCHRIFT

(11) **EP 0 459 283 B1**
(45) Veröffentlichungstag und Bekanntmachung des Hinweises auf die Patenterteilung: **23.07.1997**
(21) Anmeldenummer: 91108236.0
(22) Anmeldetag: 22.05.1991
(51) Int. Cl.: H01L 23/498, H01L 23/15

(54) **Halbleiterbauelement, befestigt an einem keramischen Substrat**
Semiconductor component mounted on a ceramic substrate
Composant semi-conducteur fixé sur un support céramique

(30) Priorität: 29.05.1990 DE 4017181
(43) Veröffentlichungstag der Anmeldung: 04.12.1991
(73) Patentinhaber: Daimler-Benz Aerospace Aktiengesellschaft, 81663 München (DE)
(72) Erfinder: Schmidt, Dieter, W-7917 Vöhringen (DE); Jarney, Günter, W-8883 Gundelfingen (DE); Holl, Bruno, Dr., W-7900 Ulm (DE); Feurer, Ernst, Dr., W-7906 Blaustein (DE)
(74) Vertreter: Fröhling, Werner Otto, Dr.

(56) Entgegenhaltungen:
- EP-A- 0 217 584
- FR-A- 2 294 610
- NEC RESEARCH AND DEVELOPMENT, Nr. 85, April 1987, Seiten 15-21; Y. KUROKAWA et al.: "Highly thermal conductive aluminium nitride substrate"

## Beschreibung

Die Erfindung betrifft ein elektrisches Bauelement nach dem Oberbegriff des Patentanspruchs 1. Die Erfindung betrifft ferner eine Anordnung, bei der ein solches Bauelement mittels eines Weichlotes auf einem Trägerkörper befestigt ist. Ein solches Bauelement ist bereits aus der EP-A- 0 217 584 bekannt.

Das dort beschriebene Bauelement besteht aus einem Keramiksubstrat, z.B. aus Aluminiumnitrid, Aluminiumoxid oder Berylliumoxid, und mindestens einem Wärme erzeugenden elektrischen Bauteil, das auf dem elektrisch isolierenden und wärmeleitenden Substrat befestigt ist. Das Bauteil ist bei dieser Lösung durch ein Hartlot auf der einen Seite des Substrats befestigt. Die dem Bauteil abgewandte andere Seite des Substrats ist mit einer Metallisierung versehen, die es gestattet, diese andere Seite durch einen Weichlötvorgang auf einem wärmeleitenden Trägerkörper zu befestigen.

Aus der FR-A- 2 294 610 ist ein Verfahren zur Beschichtung eines isolierenden Substrats mit einer elektrisch leitenden Schicht aus Titan-Kupfer-Gold sowie Palladium-Kupfer-Gold bekannt. Zwischen dieser elektrisch leitenden Schichtfolge und dem Substrat ist bei dieser Lösung eine Schicht aus Titan vorgesehen.

Bauelemente dieser Art sind insbesondere in sogenannten Leistungshybrid-Schaltungen verwendbar. Das sind Schaltungen, bei denen im allgemeinen mehrere Leistungs-Halbleiterbauelemente, z.B. Transistoren und/oder Dioden, als sogenannte Chip-Bauelemente, d.h. ohne Gehäuse, und passive Bauelemente, z.B. Widerstände und/oder Kondensatoren, auf einem Substrat befestigt und elektrisch verbunden sind, vorzugseise mit Hilfe eines auf dem Substrat angebrachten gedruckten Leiterbahnmusters. Ein derart bestücktes Substrat kann dann in einem kleinen und mechanisch robusten Gehäuse, welches elektrische Anschlüsse besitzt, untergebracht werden.

Solche Leistungshybrid-Schaltungen haben den Vorteil, daß eine hohe Packungsdichte elektronischer Bauteile möglich ist. Bei einer hohen Packungsdichte kann aber beim Betrieb dieser Schaltungen eine große Verlustwärmemenge entstehen, welche über das Substrat und das Gehäuse abgeführt werden muß, so daß insbesondere keine thermische Zerstörung der Halbleiterbauelemente entsteht. Diese setzt z.B. bei Silizium(Si)-Halbleiterbauelementen bei einer Temperatur größer 370 K ein. Solche in einem Gehäuse angebrachten Schaltungen müssen im allgemeinen allgemein anerkannte Vorschriften erfüllen, z.B. deutsche DIN- und/oder VDE-Normen und/oder amerikanische MIL-Standards.

Solche Leistungshybrid-Schaltungen und -Anordnungen erfordern daher eine wesentlich genauere Abstimmung der elektrischen, mechanischen und speziell der thermischen Eigenschaften der benutzten Materialien aufeinander als bei Hybrid-Schaltungen, die lediglich eine vernachlässigbare Verlustwärmemenge erzeugen. Wenn die von den Halbleiterbauelementen (Chips) abgegebene Verlustwärmemenge ansteigt, wird deren Ableitung ein technisch schwierig zu lösendes Problem. Es hat sich herausgestellt, daß bei Chips, die mit ihrer Halbleitersubstratseite auf dem Hybrid-Substrat, z.B. Keramik, befestigt sind, die thermische Leitung sehr wirksam ist, um die Verlustwärmemenge durch das (Keramik-)Substrat und das Gehäuse abzuleiten. Der Wärmetransport insbesondere von einem Halbleiter-PN-Übergang über das (Keramik-)Substrat zu der Außenseite des Gehäuses ist mit Hilfe des thermischen Widerstandes Rₜₕ beschreibbar.

Der Erfindung liegt daher die Aufgabe zugrunde, ein gattungsgemäßes Bauelement dahingehend zu verbessern, daß ein möglichst kleiner thermischer Widerstand entsteht, daß bei maximaler Verlustleistung der Halbleiterbauelemente eine hohe Packungsdichte erreichbar ist und daß mechanisch robuste Leistungshybrid-Schaltungsanordnungen herstellbar sind.

Diese Aufgabe wird gelöst durch die im kennzeichnenden Teil des Patentanspruchs 1 angegebenen Merkmale. Zweckmäßige Ausgestaltungen und/oder Weiterbildungen sind den Unteransprüchen entnehmbar.

Die Erfindung beruht auf der Erkenntnis, daß das (Keramik-)Substrat einerseits möglichst eine so gute thermische Leitfähigkeit wie ein Metall besitzen sollte, um dort einen möglichst kleinen thermischen Widerstand zu haben, und andererseits ein möglichst guter elektrischer Isolator mit einer hohen elektrischen Durchschlagsfestigkeit sein sollte. Ein wesentlicher Anteil des thermischen Widerstandes entsteht an den Übergängen zwischen verschiedenen Materialien, z.B. an dem (Si-)Halbleiter-(Keramik-)Substrat-Übergang und/oder an dem (Keramik-)Substrat-Trägerkörper(Gehäuse)-Übergang. Da an dem (Si-)Halbleiter-(Keramik-)Substrat-Übergang hohe elektrische und thermische Ströme auftreten können, ist es vorteilhaft, diesen Übergang als Lötverbindung auszubilden. Dieses erfordert jedoch eine genaue Anpassung der zugehörigen thermischen Ausdehnungskoeffizienten über den ganzen Temperaturarbeitsbereich, da ansonsten störende mechanische Spannungen auftreten. Weiterhin muß das (Keramik-)Substrat für elektronische Schaltungen allgemein gültige Eigenschaften besitzen, wie z.B. eine geringe Dielektrizitätskonstante, einen möglichst kleinen dielektrischen Verlustfaktor, hohe mechanische Stabilität (Zug- und/oder Biegefestigkeit), gute Laser-Bearbeitungsmöglichkeit, hohe chemische Stabilität und Nichtgiftigkeit.

Die Erfindung wird im folgenden anhand eines Ausführungsbeispiels näher erläutert.
Dabei zeigen
- FIG. 1: einen schematischen Querschnitt durch das Ausführungsbeispiel;
- FIG. 2 und 3: Diagramme zur Erläuterung der Erfindung.

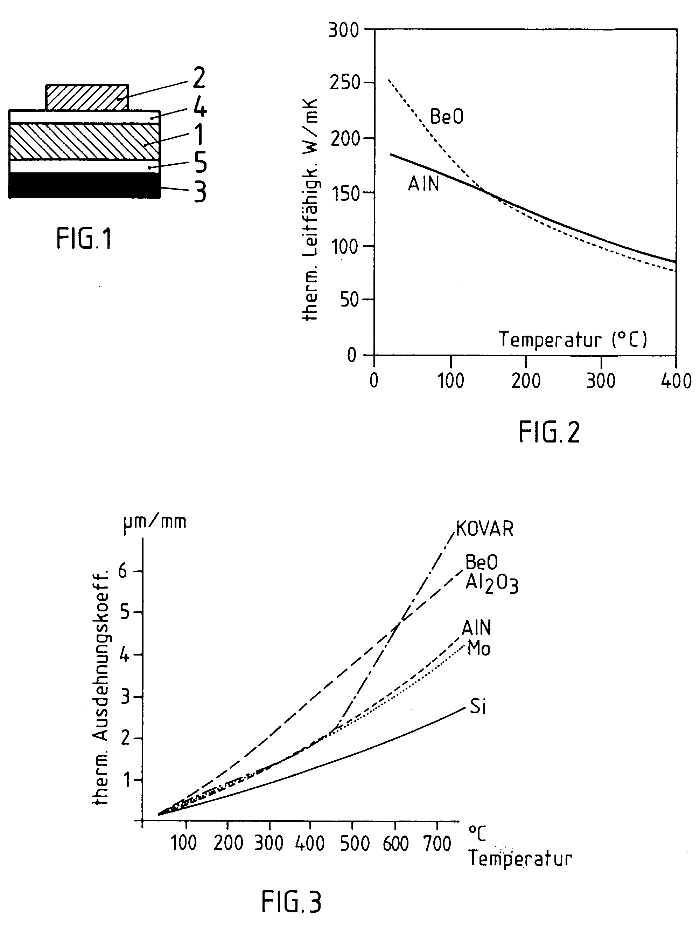

Das elektronische Bauelement gemäß FIG. 1 besteht aus einem Substrat 1, vorzugsweise aus Aluminiumnitrid(AlN)-Keramik, was nachfolgend noch näher erläutert wird. Das Substrat 1 kann alternativ jedoch auch aus Beryllium-oxid(BeO)-Keramik oder aus Aluminiumoxid(Al₂O₃)-Keramik bestehen. Das Substrat 1 ist plattenförmig und hat z.B. eine Länge von 44 mm, eine Breite von 28 mm und eine Dicke von 0,635 mm. Die thermische Leitfähigkeit beträgt 140 W/mK. Das Substrat wird zunächst mechanisch und/oder chemisch gereinigt und dann durch Sputterätzen angeätzt. Auf das derart vorbereitete Substrat 1 werden durch Sputtern zunächst eine dünne TiW (Titan Wolfram)-Schicht, Schichtdicke z.B. 40 nm, und darauf eine dünne erste Cu(Kupfer)-Schicht, Schichtdicke z.B. 1400 nm, aufgebracht.

Auf einer Seite des Substrates 1 wird nun ein Muster, z.B. ein elektrisches Leiterbahnenmuster entsprechend einem herzustellenden Netzteil, mit Hilfe eines semiadditiven Galvanikverfahrens aufgebracht. Es wird eine dicke zweite Cu-Schicht erzeugt, deren Schichtdicke z.B. 20 µm beträgt und von der zu leitenden Stromstärke abhängt. Die Leiterbahnen haben z.B. für Stromstärken bis zu 20 A eine Breite von 2 mm. Auf diese dicke zweite Cu-Schicht wird anschließend als Diffusionssperre eine ungefähr 5 µm dicke Ni(Nickel)-Schicht aufgebracht und darauf eine ungefähr 1 µm dicke Au(Gold)-Schicht, die eine gute elektrische Kontaktierung, z.B. durch Kleben, Bonden und/oder Löten, ermöglicht. Diese Schichtenfolge hat eine große Haftfestigkeit. Für einen 1 mm · 1 mm großen Meßfleck beträgt die Schälkraft mehr als 50 N, gemessen nach der Norm MIL-STD-883C, Verfahren Nr. 2019.4. Auf diese Schichtenfolge wird anschließend durch einen Hartlötvorgang ein Wärme erzeugendes Bauteil 2, z.B. ein auf einem 6,5 mm · 6,5 mm großen Silizium(Si)-Substrat aufgebauter Leistungs-Halbleiter, aufgelötet. Es entsteht eine Hartlotschicht 4, die eine Dicke von ungefähr 50 µm besitzt und im wesentlichen aus dem Hartlotmaterial 80 Au 20 Sn (80 Gew.-Proz. Gold (Au) und 20 Gew.-Proz. Zinn (Sn)) besteht. Ein solcher Leistungshalbleiter, z.B. ein MOSFET in Chip-Form, kann z.B. einen Strom bis zu 20 A schalten und erzeugt eine Verlustwärmemenge bis zu 17,5 W. Auf das (AlN)-Substrat 1 werden auf diese Weise z.B. für ein herzustellendes Netzteil bis zu sieben derartiger Leistungshalbleiter aufgelötet.

Auf den Leiterbahnen können außerdem noch weitere elektronische Bauelemente und/oder Baugruppen, z.B. Widerstände und/oder Halbleiterdioden, befestigt sein, z.B. durch Löten oder Kleben. Das derart bestückte Substrat 1 wird anschließend durch einen Weichlötvorgang auf einen Trägerkörper 3, z.B. eine mit Nickel (Dicke ungefähr 1 µm) beschichtete Molybdän(Mo)-Platte, die eine Dicke von ungefähr 1,5 mm besitzt und die ein Teil eines Gehäuses ist, aufgelötet. Dabei wird ein 96 Sn 4 Ag-Weichlot (96 Gew.-Proz. Zinn (SN) und 4 Gew.-Proz. Silber (Ag)) verwendet und es entsteht eine Weichlotschicht 5 mit einer Dicke von ungefähr 50 µm. Eine derartige Anordnung hat bei einer Temperatur von 100° C einen thermischen Widerstand Rₜₕ von ungefähr 1,2 K/W. Dieser thermische Widerstandswert ist auch in einem Temperaturbereich von ungefähr 60° C bis 150° C vorhanden.

FIG. 2 zeigt die thermische Leitfähigkeit (in der Einheit W/mK) in Abhängigkeit von der Temperatur (in der Einheit °C) für die Materialien BeO und AlN.

FIG. 3 zeigt den thermischen Ausdehnungskoeffizienten (in der Einheit µm/mm) in Abhängigkeit von der Temperatur (in der Einheit °C) für verschiedene Materialien.

Aus den FIG. 2 und 3 ist ersichtlich, daß AlN in dem unteren Temperaturbereich (kleiner ungefähr 150° C) eine günstige, mit BeO vergleichbare thermische Leitfähigkeit besitzt (FIG. 2) und einen thermischen Ausdehnungskoeffizienten, der gut an denjenigen von Molybdän (Mo) und Silizium (Si) angepaßt ist (FIG. 3). Bei der vorstehend beschriebenen Anordnung treten daher lediglich vernachlässigbare mechanische Spannungen auf.

## Patentansprüche

1. Elektrisches Bauelement, bestehend aus einem Keramiksubstrat (1) aus Aluminiumnitrid, Aluminiumoxid oder Berylliumoxid und mindestens einem Wärme erzeugenden elektrischen Bauteil (2), das auf dem elektrisch isolierenden und wärmeleitenden Substrat (1) befestigt ist, wobei das Bauteil (2) durch ein Hartlot auf der einen Seite des Substrats (1) befestigt ist und wobei die dem Bauteil (2) abgewandte andere Seite des Substrats (1) mit einer Metallisierung versehen ist, die es gestattet, diese andere Seite durch einen Weichlötvorgang auf einem wärmeleitenden Trägerkörper (3) zu befestigen, dadurch gekennzeichnet,
- daß auf den genannten, einander gegenüberliegenden Seiten des Substrats (1) jeweils eine dünne TiW-Schicht und darauf eine dünne erste Cu-Schicht aufgebracht sind, wobei diese Schichten auf der genannten abgewandten anderen Seite die genannte Metallisierung bilden, und
- daß auf der einen Seite des Substrats auf die dünne erste Cu-Schicht eine metallische Schichtenfolge, bestehend aus einer dicken zweiten Cu-Schicht, einer Ni-Schicht und einer Au-Schicht, aufgebracht ist, die als elektrisches Leiterbahnenmuster ausgebildet ist, und auf der das Bauteil (2) durch das Hartlot befestigt ist, wobei die Dicke der zweiten Cu-Schicht in Abhängigkeit von der durch diese Schicht zu leitenden Stromstärke gewählt ist.

2. Elektrisches Bauelement nach Anspruch 1, dadurch gekennzeichnet, daß das Hartlot aus einer Au-Sn-Legierung mit einem Sn-Anteil von ungefähr 20 Gew.-Proz. besteht.

3. Elektrisches Bauelement nach einem der vorhergehenden Ansprüche, dadurch gekennzeichnet, daß das Bauteil (2) als Leistungs-Halbleiterbauelement, das auf einem Silizium-Substrat basiert, ausgebildet ist.

4. Anordnung, bestehend aus mindestens einem elektrischen Bauelement nach einem der vorhergehenden Ansprüche und aus dem Trägerkörper (3), dadurch gekennzeichnet, daß das Substrat (1) durch ein Weichlot, bestehend aus einer Sn-Ag-Legierung mit einem Ag-Anteil von ungefähr 4 Gew.-Proz., auf dem Trägerkörper (3) befestigt ist.

5. Anordnung nach Anspruch 4, dadurch gekennzeichnet,
- daß die TiW-Schicht eine Dicke von ungefähr 40 nm besitzt,
- daß die erste Cu-Schicht eine Dicke von ungefähr 1400 nm hat,
- daß die zweite Cu-Schicht nach einem semiadditiven Galvanikverfahren aufgebracht ist,
- daß die Ni-Schicht eine Dicke von ungefähr 5 µm besitzt,
- daß die darauf angebrachte Au-Schicht eine Dicke von ungefähr 1 µm hat,
- daß das Hartlot zwischen der Au-Schicht und dem Bauteil (2) eine Schichtdicke von ungefähr 50 µm besitzt, und
- daß das Weichlot zwischen dem Substrat (1) und dem Trägerkörper (3) eine Schichtdicke von ungefähr 50 µm besitzt.

6. Anordnung nach einem der Ansprüche 4 und 5, dadurch gekennzeichnet, daß der Trägerkörper (3) aus einer mit Ni beschichteten, Mo-haltigen Metallplatte besteht, deren thermischer Ausdehungskoeffizient ungefähr gleich demjenigen des Substrats ist.

## Claims

1. An electrical component comprising a ceramic substrate (1) of aluminium nitride, aluminium oxide or beryllium oxide and at least one heat generating electrical component part (2) secured to said electrically insulating and heat conducting substrate (1), said component part (2) being secured to one side of said substrate (1) by means of a brazing solder and the other side of said substrate (1) facing away from said component part (2) being metallized in a manner permitting said other side to be secured to a heat conducting plate (3) by a soft soldering process, characterized in that
- a thin TiW layer followed by a thin first Cu layer are applied to each of said opposite sides of said substrate (1), said layers providing the said metallizing on the said other side facing away from said component part (2), and
- a plurality of metallic layers comprising a thick second Cu layer, an Ni layer and an Au layer which form a land pattem and to which the said component part (2) is secured by means of the said brazing solder are applied to said one side of the said substrate on top of the said thin first Cu layer, the thickness of said second Cu layer being selected to suit the amperage of the current to be conducted through that layer.

2. An electrical component as claimed in Claim 1, characterized in that said brazing solder consists of an Au-Sn alloy with an Sn content of about 20 percent by weight.

3. An electrical component as claimed in any one of the preceding claims, characterized in that said component part (2) is a power semiconductor element based on a silicon substrate.

4. An arrangement comprising at least one electrical component as claimed in any one of the preceding claims and said plate (3), characterized in that said substrate (1) is secured to said plate (3) by means of a soft solder consisting of an Sn-Ag alloy with an Ag content of about 4 percent by weight.

5. An arrangement as claimed in Claim 4, characterized in that
- the said TiW layer has a thickness of about 40 nm,
- the said first Cu layer has a thickness of about 1400 nm,
- the said second Cu layer is applied by a semi-additive electroplating process,
- the said Ni layer has a thickness of about 5 µm,
- the said Au layer applied on top of said Ni layer has a thickness of about 1µm,
- the said braizing solder between the said Au layer and the said component part (2) has a thickness of about 50 µm, and
- the said soft solder between the said substrate (1) and the said plate (3) has a thickness of about 50 µm.

6. An arrangement as claimed in any one of Claims 4 or 5, characterized in that the said plate (3) consists of an Ni-coated metal plate containing Mo, the coefficient of thermal expansion of which is approximately equal to that of the said substrate

## Revendications

1. Elément électrique comprenant un substrat céramique (1) en nitrite d'aluminium, alumine ou oxyde de béryllium et au moins un élément électrique (2) générant de la chaleur, fixé sur le substrat (1) à isolation électrique et thermoconducteur, l'élément (2) étant fixé sur l'un des côtés du substrat (1) par le biais d'un métal d'apport de brasage fort et l'autre côté du substrat (1) opposé à l'élément (2) étant muni d'une métallisation permettant de fixer cet autre côté au moyen d'un processus de brasage tendre sur un support (3) conducteur, **caractérisé en ce que**
- sur les côtés opposés cités du substrat (1) une mince couche de TiW peut respectivement y être appliquée et là-dessus une première couche mince de Cu, ces couches formant sur l'autre côté opposé la dite métallisation, et
- que d'un côté du substrat une série de couches métalliques, comprenant une deuxième couche épaisse de Cu, une couche de Ni et une couche de Au, est appliquée sur la première couche mince de Cu, ces couches formant un réseau électrique de pistes conductives sur lequel est fixé l'élément (2) par brasage dur, l'épaisseur de la deuxième couche de Cu étant choisie en fonction de l'intensité électrique à conduire à travers cette couche.

2. Elément électrique selon la revendication 1, caractérisé en ce que le métal d'apport de brasage dur consiste en un alliage Au-Sn avec une part de Sn d'environ 20 pourcents en poids.

3. Elément électrique selon l'une des revendications précédentes caractérisé en ce que l'élément (2) est conçu comme élément semi-conducteur de puissance basé sur un substrat de silicium.

4. Disposition comprenant au moins un élément électrique selon l'une des revendications précédentes et un support (3), caractérisée en ce que le substrat (1) est fixé sur le support (3) par un brasage tendre consistant en un alliage Sn-Ag avec une part d'Ag d'environ 4 pourcents en poids.

5. Disposition selon la revendication 4, caractérisée en ce que
- la couche TiW a une épaisseur d'environ 40 nm,
- la première couche Cu a une épaisseur d'env. 1400 nm,
- la deuxième couche Cu est appliquée selon un procédé galvanique semi-additif,
- la couche Ni a une épaisseur d'environ 4 µm,
- la couche Au y appliquée a une épaisseur d'environ 1 µm,
- que l'apport de brasage fort entre la couche Au et l'élément (2) présente une épaisseur de couche d'environ 50 µm, et
- l'apport de brasage tendre entre le substrat (1) et le support (3) a une épaisseur de couche d'environ 50 µm.

6. Disposition selon l'une des revendications 4 et 5, caractérisée en ce que le support (3) consiste en une plaque métallique à base de Mo revêtue de Ni, le coefficient de dilatation de laquelle est le même que celui du substrat.
